Europäisches Patentamt

(19) European Patent Office

Office européen des brevets

(11) Publication number : **0 460 918 B1**

(12) **EUROPEAN PATENT SPECIFICATION**

(45) Date of publication of patent specification :
06.09.95 Bulletin 95/36

(21) Application number : **91305045.6**

(22) Date of filing : **04.06.91**

(51) Int. Cl.⁶ : **H01L 29/772**

(54) **Semiconductor device having improved insulated gate type transistor.**

(30) Priority : **04.06.90 JP 144544/90**

(43) Date of publication of application :
**11.12.91 Bulletin 91/50**

(45) Publication of the grant of the patent :
**06.09.95 Bulletin 95/36**

(84) Designated Contracting States :
**AT BE CH DE DK ES FR GB GR IT LI LU NL SE**

(56) References cited :
**WO-A-86/03341
GB-A- 2 195 663
US-A- 4 910 564
PATENT ABSTRACTS OF JAPAN vol. 18, no.
201 (E-757)(3549) 12 May 1989 & JP-A-01 021
968
PATENT ABSTRACTS OF JAPAN vol. 9, no.
102 (E-312)(1825) 4 May 1985 & JP-A-59 228 762**

(56) References cited :
**IBM TECHNICAL DISCLOSURE BULLETIN,
vol. 29, no. 10, March 1987, NEW YORK US,
pages 4305-4307; 'TRENCH MOSFETS (3-D
STRUCTURE)'**

(73) Proprietor : **CANON KABUSHIKI KAISHA
30-2, 3-chome, Shimomaruko,
Ohta-ku
Tokyo (JP)**

(72) Inventor : **Matsumoto, Shigeyuki, Canon
Kabushiki Kaisha
30-2, 3-chome, Shimomaruko
Ohta-ku, Tokyo (JP)**

(74) Representative : **Beresford, Keith Denis Lewis
et al
BERESFORD & Co.
2-5 Warwick Court
High Holborn
London WC1R 5DJ (GB)**

## Description

This invention relates to a semiconductor integrated circuit device such as memory, photoelectric converting device, signal processing device, etc. to be mounted on various electronic instruments, particularly an insulated gate transistor thereof.

In recent years, as an effort for higher integration, it has been desired to develop practically finely worked functional devices such as MOS transistors with a gate length of submicron order.

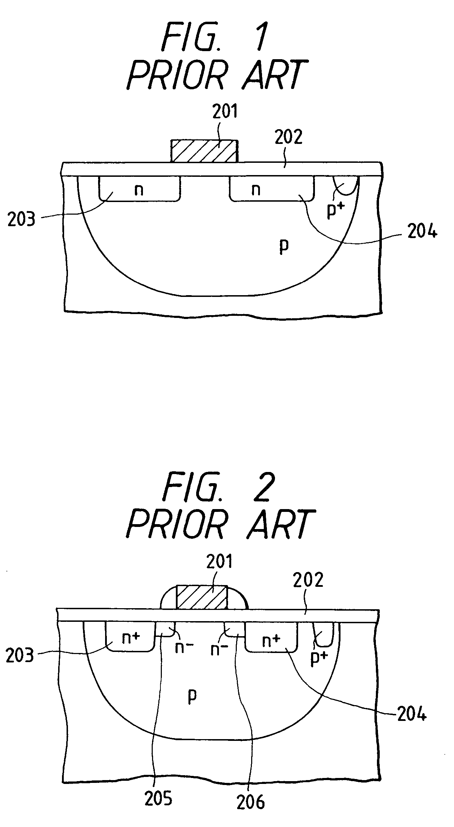

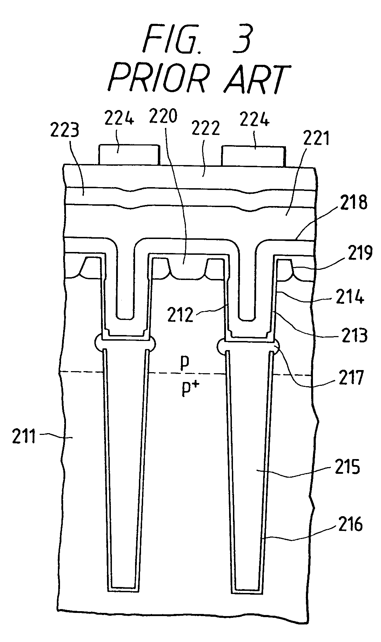

Fig. 1 to Fig. 3 are schematic sectional views showing the structure of MOS transistors of the prior art. Fig. 1 is N-MOS transistor with a single drain structure having a gate 201, an oxidised film 202, a source 203 and a drain 204, which is the simplest structure, and its production process is also simple. However, with the progress of finer formation of the device, when the gate length becomes 1.2 µm or less, deterioration of the actuation of the MOS transistor will occur. Fig. 2 has low concentration regions 205 and 206 provided for relaxing the electrical field between the source and the drain for preventing such deterioration, and is called a LDD (lightly doped drain) structure. Further, for DRAM, which is most advanced in finer formation, a thin Transistor cell (TTC) as shown in Fig. 3 has been proposed. TTC has a groove provided in the semiconductor substrate 211, and a transistor and a capacitor are formed at the same time. More specifically, it has a gate oxidised film 213, with a channel 214 located on the side face of the gate oxidised film. In the groove at the lower part of the gate 212, polycrystalline Si 215 is filled and deposited to form an electrode of the capacitor for memory, with its surface being oxidised to form an insulator film 216 for capacitor. A buried source 217 is formed at the upper part of the polycrystalline Si 215. Further, it is equipped with a word line 218 of polycrystalline Si, an N+ diffusion layer as a drain and bit line, and is separated electrically by oxidised film 220 from the adjacent cells. On insulation film 221, and interlayer insulation film 222 are respectively formed wiring patterns 223 and 224. The TTC, having the MOS transistor and capacitor formed in the vertical direction, has such advantages that it is smaller in area, and also erroneous actuation due to influence of α-ray will occur with difficulty, and further it is free from parasitic transistor.

However, the groove type transistor cell as described above has still room to be improved in the following respects:

1) In the semiconductor device shown in Fig. 3, only with respect to the transistor portion, the aspect ratio (groove depth/opening diameter) is about 2, and therefore the yield is lowered by defects which occur in Si etching, and further it is difficult to form insulation film of uniform and good quality in the groove, thus posing a problem in reliability.

2) Furthermore, polycrystalline silicon, which is the gate electrode member material generally used in TTC, cannot be made with resistivity of 1 mΩcm or lower, even if impurity is diffused to the maximum extent, whereby it is impossible to reduce the propagation delay time which determines the speed of the transistor. Even if a silicide (Si metal alloy) is employed in place of polycrystalline silicon, the resistivity is about 100 to 200 µΩcm and a transistor of high speed, high yield and high reliability cannot be obtained.

3) Furthermore, generally speaking, the gate electrode is deposited on the semiconductor device surface uniformly and therefore the surface of the gate electrode reflects the unevenness itself of the groove, as opposite to flattening. Shortly speaking, for maintaining high reliability of the wiring deposited on the gate electrode, an insulation film must be deposited on the gate electrode, and flattened using rf plasma etchback. This method is a method which leaves the resist thickly only at the concavity and etches simultaneously the insulation film at the resist concavity in rf plasma, and since the influence of rf exerted on the MOS transistor is extremely great, the risk of impairing yield and reliability has been very great.

IBM Disclosure Bulletin, vol. 29, No. 10, pages 4305-4307 describes a 3-D structure trench MOSFET having deep implant source and drain regions each side of an insulated buried gate electrode.

United States Patent 4,910,564 describes another structure having deep source and drain regions of n-type and of p-type with n & p channels each side of an insulated buried gate electrode.

International Patent Application WO 86/03341 describes a multi-gate trench transistor having a thin film gate electrode extending along the sidewalls and floor of adjacent recesses.

Of particular note Patent Abstracts of Japan, vol.9, No. 102 and JP-A-59 228 762 discloses an insulated gate transistor comprising an insulated gate transistor comprising:

a semiconductor body having a recess therein;

a gate electrode filling the recess;

an insulating film between the gate electrode and the sidewall periphery of the recess;

first and second semiconductor regions in the surface of the semiconductor body, positioned each side of the gate electrode, and defining a source and a drain, respectively,

a first channel means between the source and the drain providing a first current path which at least in part is in directions substantially perpendicular to the surface of the semiconductor body; and

a second channel means between the source and the drain providing a second current path in a direction substantially parallel to the surface of the semiconductor body.

The present invention is intended to overcome the problems described above.

The transistor according to the present invention, while having the features of JP-A-59 228 762 described above, is characterised by a high impurity doped region, located immediately below the gate electrode, disposed to lie in the first current path and thereby providing part of the first channel means.

Preferably, the gate electrode is of a composite structure comprising a metal filling and a polycrystalline silicon film located between the metal filling and the insulating film. The metal filling may be of single crystalline aluminium or aluminium alloy, one of the alloys Al-Si, Al-Ti, Al-Cu, Al-Si-Ti, Al-Si-Cu.

Since the gate electrode is buried at the surface to a lower part of the semiconductor substrate, an MOS transistor with small area and a flat surface can be realised, and an MOS transistor having high reliability can be obtained.

In the accompanying drawings:

Figs. 1 to 3 are each a sectional view of an MOS transistor of the prior art;

Figs. 4A and 4B are a plan view and a sectional view of an example of the present invention;

Figs. 5A to 5G are schematic sectional views for illustrating preparation of the example shown in Fig. 4;

Fig. 6 is a schematic view showing an example of a film forming apparatus which can be used for preparation; and

Figs. 7A to 7D are schematic views for illustrating film forming used in gate electrode production and for wiring .

So that this invention may be better understood, a preferred embodiment will be described below, making reference to the drawings. The following description is given by way of example only.

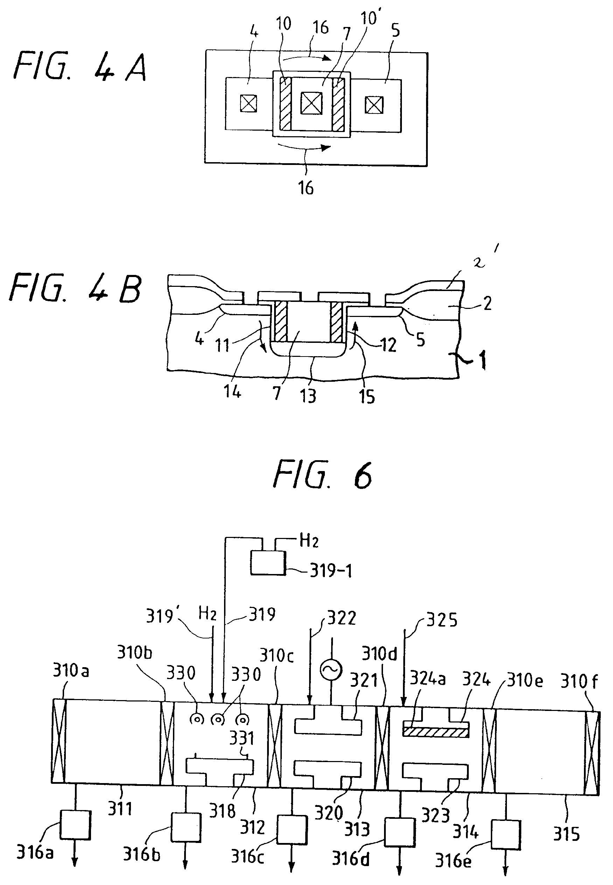

Figs. 4A and 4B illustrate a preferred embodiment of the present invention.

The gate electrode 7 of this MOS transistor is buried and thus extends from the surface into the body of the semiconductor substrate 1. A part of the channel for effecting transistor actuation of the MOS transistor is below the surface.

Further, a part or all of the gate electrode is formed by selective deposition using a chemical gas phase reaction, and so can be formed flush with the surface of the semiconductor device. For forming the gate electrode in a recess and also accomplishing flatness of the semiconductor device surface, the metal system film selective deposition method of Al, etc. described below is effective.

Figs. 4A and 4B show an NMOS transistor as an example of the present invention. Fig. 4A is a plan view of the NMOS transistor which is surrounded by a P well 1 and a field oxide film 2. Fig. 4 is a sectional view.

The source 4 and the drain 5 of the present NMOS transistor are arranged each side of a recess, and adjacent to the source 4 and the drain 5 are respectively arranged a gate oxide film 11,12 which extends in the vertical direction from the surface to a lower part of the substrate, and adjacent to the gate oxide film 11,12 there is buried from the substrate surface the gate electrode 7 extending deeply below the source 4 and the drain 5. Between the source 4 and the drain 5 a channel for flowing current is provided. This includes a high impurity doped region (n+) 13 provided immediately below the gate electrode 7.

The surface of the present transistor is approximately flat because the control electrode region is buried.

The transistor is covered on the surface with an interlayer insulation film 2', and metal wiring of Al (not shown). Contact holes are provided in the interlayer insulation film 2' for making contact to the source 4, the drain 5 and the gate electrode 7. Also in the formation step of the metal wiring there may be employed a method in which Al, etc. is deposited selectively within each contact hole, namely only on the semiconductor substrate and then a wiring material is deposited on the whole surface of the insulation film, and wiring is formed by patterning.

Next, actuation is described.

The MOS transistor according to the present invention is a device which controls the conductance of the channel between the source electrode 4 and the drain electrode 5 by the gate electrode 7. When a voltage $V_D$ is applied between the source electrode 4 and the drain electrode 5, if a voltage $V_G$ is applied to the gate electrode 7, current flows based on the following formulae, namely:

when $V_D < V_G\text{-}V_T$

$$I_D = \frac{W}{L}\mu \, Cox[(V_G - V_T)V_D - \frac{1}{2}V_D^2]$$

when $V_D > V_G\text{-}V_T$

$$I_D = \frac{1}{2}Cox \cdot \mu \cdot \frac{W}{L}(V_G - V_T)^2$$

(Cox: gate capacity, $\mu$: carrier mobility, W: channel width, L: channel length, $V_T$: threshold value voltage).

The current from the source 4 to the drain 5 flows in the direction of the arrowhead 14 to flow into the high impurity region (n+) 13 provided immediately below the gate electrode 7. Further, the current flows in the direction of the arrowhead 15 by passing through the channel 12 to flow into the drain electrode 5. In the current, there exists a current component which flows in the vertical direction to the surface, and at the same time a component which flows in the direction shown by the arrow head 16 in Fig. 4A and parallel to the surface.

At present, what is demanded for MOS transistors is 1) to make the transistor of small area, and 2) to perform transistor actuation at high speed.

The present example has made improvements to a great extent concerning the two points as mentioned above, and the area of the transistor can be reduced to 80% of that of the prior art. Concerning speed, the resistance of the gate electrode is an important factor. In the case of polycrystalline Si gate electrodes which have been used in the prior art, the resistance is 300 to 80 $\Omega$/cm$^2$, and 2 to 5 $\Omega$/cm$^2$ has been accomplished by silicide formation, while in the case of this example a low resistance of 1 x 10-5 $\Omega$/cm$^2$ can be realised if single crystalline Al is used as a metal filling.

In the present example the gate electrode 7 is a composite of polycrystalline Si film 109 and metal filling 111. The polycrystalline crystalline film 109 is located between the metal filling 111 and the sidewalls of the recess so that the channel will not contact the metal filling 111 of the gate electrode 7 through the insulation film 11,12 (108). Also by using polycrystalline silicon Si, which is used in the process of the prior art, and thus without involving the work function of the gate electrode filling 111, an MOS transistor having the same characteristics as in the prior art can be obtained. Further, because the direct resistance of the gate electrode is reduced, a fine MOS transistor of high speed can be obtained.

Next, the process for preparing the transistor shown in Fig. 4 will be described. Fig. 5A to 5G show sectional views.

First, a P well 102 is formed in an N type Si substrate 101, and an oxidised film 103 with a thickness of 1200 nm (12000 Å) on the substrate surface is formed and then partially removed to produce a patterned mask.

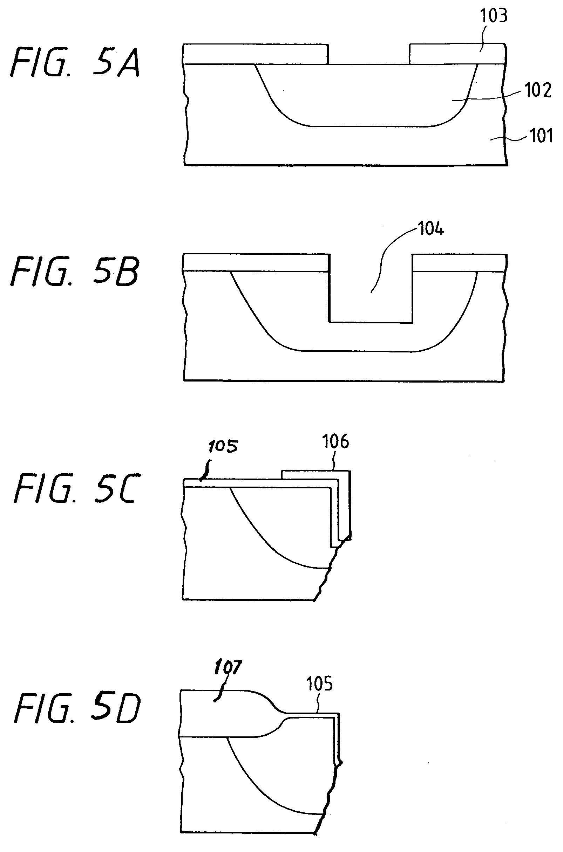

Next, using the oxidised film 103 as a mask, the substrate is etched by RIE (reaction ion etching) using gases of $Cl_2$, $CBrF_3$, to form a recess 104. The etching depth of the substrate is 3 μm (Fig. 5B).

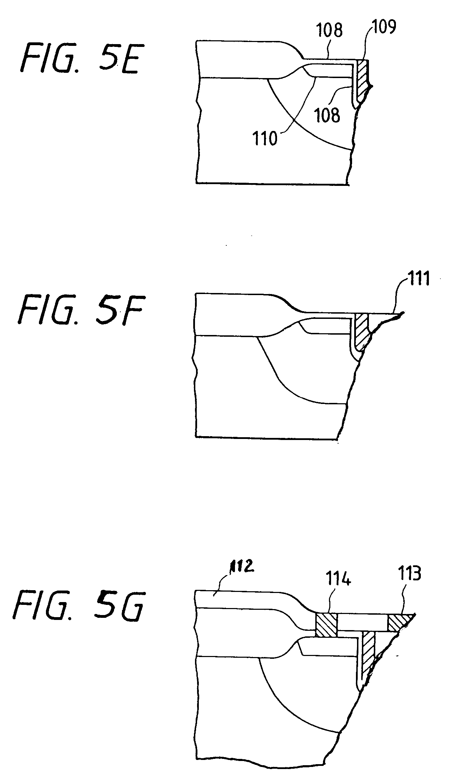

Next, the above oxidised film 103 is removed then a thermally oxidised film 105 is produced and an SiN film 106 with a thickness of 100 nm (1000 Å) on the whole substrate surface, followed by partial removal of the SiN film (Fig. 5).

Using the known LOCOS method, a field oxidised film 107 is formed only at portions where the SiN film 106 has been removed. The formation conditions are $O_2$: 2 liter/min., $H_2$: 4 liter/min., oxidation temperature 1000°C., film thickness 800 (8000 Å). Then, the SiN film 106 is removed (Fig. 5D).

Next, after the oxidised film 105 on the substrate is completely removed in HF atmosphere, a gate insulation film 108 is formed. The formation temperature is 850°C., and the film thickness 18 nm (180Å). As a part of the gate electrode of the MOS transistor, a polycrystalline Si film 109 is formed on the whole surface of the gate insulation film 108 by pyrolysis of $SiH_4$ and is partially removed by RIE in a $CCl_2F_2$ atmosphere. Further, for formation of the source and drain diffusion layer 110 of the MOS transistor, arsenic is ion injected at 5 x 10$^{15}$ ions/cm$^2$. Arsenic is also injected into the polycrystalline Si film 109 to play a role of lowering specific resistance of the polycrystalline Si. Next, for activating electrically the source and drain diffusion layer 110, heat treatment was carried out at 1000°C for 15 seconds according to the RTA (rapid thermal annealing) method. (Fig. 5E).

Next, Al 111 is deposited on the polycrystalline Si film 109 to fill the recess.

The deposition method is described below. First, the substrate is placed in a reaction chamber of a CVD apparatus, and the reaction chamber is internally evacuated to 1.3 x 10$^{-6}$ Pa (1 x 10$^{-8}$ Torr). Through a feeding gasline, DMAH is fed. For the carrier gas, He is employed. Further, through another gasline, $H_2$, as the reaction gas, is permitted to flow onto the substrate which is heated to 270°C. A typical pressure in this case is ca. 2.0 x 10$^2$ Pa (1.5 Torr), and the partial pressure of DMAH ca. 6.7 x 10$^{-1}$ Pa (5 x 10$^{-3}$ Torr). According to this method, Al is deposited selectively only on the electroconductive polycrystalline Si film 109 and not deposited on the oxidised film 108 and the field oxidised film 107. Hence, Al filling 111 forms the rest of the gate electrode of the MOS transistor (Fig. 5F).

Next, borophosphosilicate glass (BPSG) is deposited as an interlayer insulation film 112, contact holes are opened and Al 114 is buried within the contact holes by the Al-CVD method as described above to produce electrode contacts 113, 114 to the gate electrode 111, the source 110 and the drain (Fig. 5G).

The preferred film forming method is one forming the deposited film by a surface reaction on an electron-donative substrate and in which a gas of an alkylaluminium hydride and hydrogen gas (hereinafter called the Al-CVD method) are used as gaseous reagents.

Particularly, by use of monomethylaluminium hydride (MMAH) as the starting gas or dimethylaluminium hydride (DMAH) as the starting gas, and $H_2$ as the reactive gas, and heating the substrate surface in a mixture of these gases, an Al film of good quality can be deposited. Here, during the selective deposition of Al, it is preferable to maintain the surface temperature at the decomposition temperature of the alkylaluminium hydride or higher and less than 450°C., more preferably 260°C to 440°C.

As the method for heating the substrate to the above-mentioned temperature range, there are direct heating and indirect heating. Particularly, by maintaining the substrate at the above-mentioned temperature by direct heating, an Al film of good quality can be formed at high deposition speed. For example, when the substrate surface 43 temperature during Al film formation is made 260°C to 440°C. which is the more preferable temperature range, a film of good quality can be obtained at higher deposition speed of 30 to 500 nm/min (300 to 5000 Å/min) which is higher than in the case of resistance heating. As such direct heating method (substrate itself is heated by direct transmission of the energy from the heating means to the substrate), for example, lamp heating by means of halogen lamps, xenon lamps, etc. may be included. As the method for indirect heating, there is resistance heating, by which heating can be performed by use of a heat-generating body, etc. provided at the substrate supporting member for supporting the substrate to form deposited film arranged in the space for formation of the deposited film.

By applying the CVD method to a substrate having an electron-donative surface portion and a non-electron donative surface portion both present thereon, a single crystal of Al can be formed only on the electron-donative substrate surface portion with good selectivity. The Al thus formed will have many excellent characteristics desirable for electrode/wiring material. A reduction of generation probability of hillocks and reduction of generation probability of alloy spikes is accomplished.

This may be considered to be due to the fact that substantially no formation of alloy spikes on account of the eutectic reaction with underlying subbing silicon, is seen, because Al of good quality can be formed on the surface comprising a semiconductor or an electroconductive member as the electron-donative surface, and also the Al is excellent in crystallinity. And, when employed for the electrode of a semiconductor device, an effect surpassing the concept of the Al electrode which has been contemplated in the prior art, and could not be even expected in the prior art can be obtained.

The Al deposited on the electron-donative surface, for example, within the recess extending from the semiconductor substrate surface has a single crystalline structure, when produced by the Al-CVD method. Metal film composed mainly of Al as described below also can be selectively deposited, and its film quality also exhibits excellent characteristics.

For example, in addition to a gas of an alkylaluminium hydride and hydrogen,

a gas containing Si atoms such as $SiH_4$, $Si_2H_6$, $Si_3H_8$, $Si(CH_3)_4$, $SiCl_4$, $SiH_2Cl_2$, $SiHCL_3$, or the like,

a gas containing Ti atoms such as $TiCl_4$, $TiBr_4$, $Ti(CH_3)_4$, etc., a gas containing Cu atoms such as copper bisacetylacetonate $Cu(C_5H_7O_2)$, copper bisdipivaloylmethanite $Cu(C_{11}H_{19}O2)_2$, copper bishexafluoroacetylacetonate $Cu(C_5HF_6O_2)_2$, etc.

may be introduced to form a gas mixture atmosphere, to form electrodes by selective deposition of electroconductive material such as Al-Si, Al-Ti, Al-Cu, Al-Si-Ti, Al-Si-Cu, etc.

The Al-CVD method as described above is a film forming method excellent in selectivity, and also the surface characteristic of the film formed has good surface characteristic. Hence, by application of a non-selective film forming method to the next deposition step, Al or a metal film composed mainly of Al also can be formed on the Al film selectively deposited as described above and $SiO_2$, etc. as the insulating film, whereby a metal film having high usability for general purpose as the wiring of semiconductor device can be obtained.

Specific examples of such metal film include the following. There may be included combinations of Al, Al-Si, Al-Ti, Al-Cu, Al-Si-Ti, Al-Si-Cu, etc. deposited selectively with Al, Al-Si, Al-Ti, Al-Cu, Al-Si-Ti, Al-Si-Cu, etc.

As the film forming method for non-selective deposition, there are other CVD methods than the Al-CVD method as described above, the sputtering method, etc. (Film forming Apparatus).

Next, the preferred film forming apparatus for forming electrodes will be described.

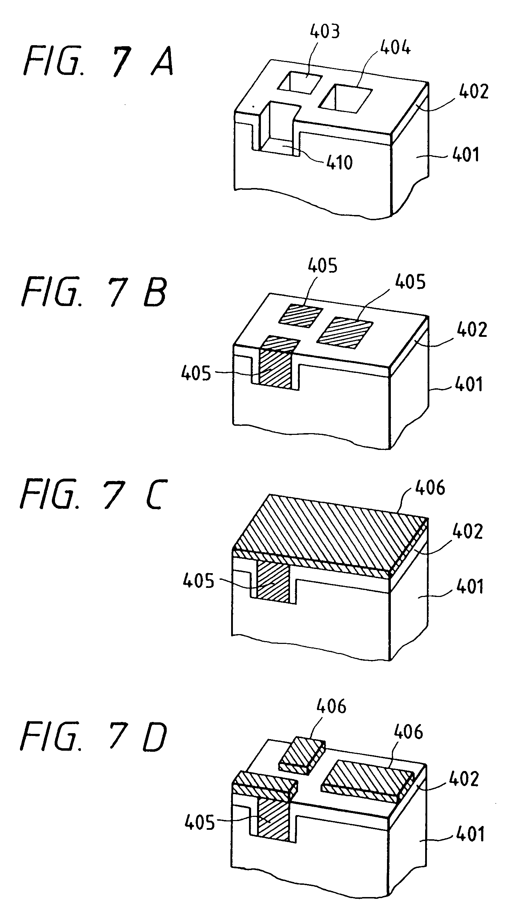

Fig. 6 shows schematically a sequential metal film forming apparatus for applying the film forming method as described above.

The sequential metal film forming apparatus, as shown in Fig. 6, is constituted by a loadlock chamber 311 connected mutually communicated under shielding from outer air through gate valves 310a to 310f, a CVD reaction chamber 312 as the first film forming chamber, an Rf etching chamber 313, a sputtering chamber 314 as the second film forming chamber and a loadlock chamber 315. The respective chambers are evacuated by evacuation systems 316a to 316e. Here, the above loadlock chamber 311 is a chamber for replacing the substrate atmosphere before deposition treatment with $H_2$ atmosphere after evacuation in order to improve throughput characteristics. The next CVD reaction chamber 312 is a chamber for selective deposition on the substrate according to the Al-CVD method as described above under normal pressure or reduced pressure, in which halogen lamps 330 are provided as a direct heating means. A substrate holder 318 is provided with pins 331 for supporting the substrate. Starting gases such as alkylaluminium hydride etc bubbled and gasified in a bubbler 319-1 are introduced into the chamber through a starting gas introducing line 319 and also hydrogen gas as a reactive gas is introduced through a gasline 319′. The next Rf etching chamber 313 is a chamber for carrying out cleaning of the substrate surface after selective deposition or etching under Ar atmosphere, and internally thereof are provided at least a substrate holder 320 capable of heating the substrate to a range of 100°C to 250°C and an electrode line for Rf etching 321, and also an Ar gas feeding line 322 is connected. The next sputtering chamber 314 is a chamber for depositing non-selectively a metal film by sputtering under Ar atmosphere on the substrate surface, and internally thereof are provided a substrate holder 323 heated within a range of 200°C to 250°C and a target electrode 324 for mounting a sputter target material 324a, and also an Ar gas feeding line 325 is connected. The final loadlock chamber 315 is a control chamber before taking out the substrate after completion of the metal film deposition into the outer air, and constituted so that the atmosphere may be replaced with $N_2$.

Fig. 7 is a schematic perspective view for illustration of a film forming procedure for formation of electrodes and wiring.

First, an outline is described. A semiconductor substrate, having openings formed in an insulating film, is prepared, which substrate is arranged in a film forming chamber, and its surface is maintained at, for example, 260°C. to 450°C. to deposit selectively Al at the portions where the semiconductor is exposed according to the hot CVD method in a mixed atmosphere of DMAH, as the alkylaluminium hydride,and hydrogen gas. Of course, as described above, a metal film composed mainly of Al such as Al-Si, etc. instead may be deposited selectively by introducing a gas containing Si atoms, etc. Next, on the selectively deposited Al and on the insulating film, Al, or an alloy film composed mainly of Al, is non-selectively formed by sputtering. Then, by patterning of the non-selectively deposited metal film to a desired wiring shape, electrodes and wiring can be formed.

Referring next to Fig. 6 and Fig. 7, a more detailed description is given. First, substrate is prepared. As the substrate, for example, a single crystalline Si wafer having an insulating film provided with different size openings is prepared.

Fig. 7A is a schematic view showing a part of the substrate. Here, 401 is a single crystalline silicon substrate 402 a thermally oxidised silicon film. 403 and 404 are openings different in size from each other. 410 denotes the bottom of a recess where Si is exposed.

The procedure for forming the first wiring layer on the substrate will now be described with reference to Figs. 6 and 7.

First, the substrate as described above is arranged in the loadlock chamber 311. Hydrogen is introduced into the loadlock chamber 311 to make it under hydrogen atmosphere. The reaction chamber 312 is internally evacuated to approximately $1.3 \times 10^{-6}$ Pa ($1 \times 10^{-8}$ Torr) by the evacuation system 316b. However, Al film can be formed even if the vacuum within the reaction chamber 312 is lower than $1.3 \times 10^{-6}$ Pa ($1 \times 10^{-3}$ Torr).

The gas of DMAH is bubbled from the gasline 319. For the carrier gas for the DMAH line, $H_2$ is employed.

The second gasline 319′ is for $H_2$ as the reaction gas, and by flowing $H_2$ through the second gas line 319′ and controlling the opening of the slow leak valve (not shown) to adjust the pressure within the reaction chamber 312 to a predetermined value. A typical pressure in this case is preferably about $2 \times 10^2$ Pa (1.5

Torr). Through the DMAH line, DMAH is introduced into the reaction tube. The total pressure is made about $2 \times 10^2$ Pa (1.5 Torr), and the DMAH pressure $6.7 \times 10^{-1}$ Pa ($5.0 \times 10^{-3}$ Torr). Then, current is passed to the halogen lamps 330 to heat directly the wafer. Thus, Al is selectively deposited.

After elapse of a predetermined deposition time, feeding of DMAH is stopped. The predetermined deposition time of the Al film deposited in this process is the time taken for the thickness of the Al film on the Si (single crystalline silicon substrate 401) to become equal to the film thickness of the $SiO_2$ (thermally oxidised silicon film 402), and can be determined previously by experimentation.

The temperature of the substrate surface by direct heating at this time is made about 270°C. According to the steps up to this stage, the Al film 405 is selectively deposited within the openings and the grooves as shown in Fig. 7B.

All of the steps as described above are referred to as the first film forming step for formation of electrodes within contact holes.

After the above first film forming step, the CVD reaction chamber 312 is evacuated until reaching a vacuum degree of $6.7 \times 10^{-1}$ Pa ($5 \times 10^{-3}$ Torr) or lower by the evacuation system 316b. At the same time, the Rf etching chamber 313 is evacuated to $6.7 \times 10^{-4}$ Pa ($5 \times 10^{-6}$ Torr) or lower. After confirmation that both chambers have reached the above vacuum degree, the gate valve 310c is opened, the substrate moved from the CVD reaction chamber 312 to the Rf etching chamber 313 by the conveying means, and the gate valve 310c closed. The substrate is conveyed to the Rf etching chamber 313, and the Rf etching chamber 313 is evacuated by means of the evacuation system 316c until reaching a vacuum degree of $10^{-4}$ Pa ($10^{-6}$ Torr) or lower. Then, argon is fed through the argon feeding line 322 for Rf etching, and the Rf etching chamber 313 maintained under an argon atmosphere of 10 to $10^{-1}$ Pa ($10^{-1}$ to $10^{-3}$ Torr). The substrate holder 320 of Rf etching is maintained at about 200°C, Rf power of 100 W supplied to the electrode for Rf etching 321 for about 60 seconds, and discharging of argon is caused to occur within the Rf etching chamber 313 for about 60 seconds. By doing so, the surface of the substrate can be etched with argon ions to remove unnecessary surface layer of the CVD deposited film. The etching depth in this case is made about 10 nm (100 Å) in terms of the oxide. Here, surface etching of the CVD deposited film is effected in the Rf etching chamber, but since the surface layer of the CVD film of the substrate conveyed through vacuum contains no oxygen, etc., no Rf etching may be effected. In that case, the Rf etching chamber 313 functions as a temperature changing chamber for effecting temperature change within a short time, when the temperatures in the CVD reaction chamber 12 and the sputtering chamber 314 are greatly different.

In the Rf etching chamber 313, after completion of Rf etching, flowing of argon is stopped, and the argon within the Rf etching chamber 313 is evacuated. After the Rf etching chamber 313 is evacuated to 6.7 x 10$^{-4}$ Pa (5 x 10$^{-6}$ Torr) and the sputtering chamber 314 to 6.7 x 10$^{-4}$ Pa (5 x 10$^{-6}$ Torr) or lower, the gate valve 310d is opened. Then, the substrate is moved from the Rf etching chamber 313 to the sputtering chamber 314 by means of a conveying means, followed by closing of the gate valve 310d.

After the substrate is conveyed to the sputtering chamber 314, the sputtering chamber 314 is made under an argon atmosphere of 10 to 10$^{-1}$ Pa (10$^{-1}$ to 10$^{-3}$ Torr) similarly as in the Rf etching chamber 313, and the temperature of the substrate holder 323 for mounting the substrate set to about 200 to 250°C. And discharging of argon is effected at a DC power of 5 to 10 kw to cut a target material such as Al or Al-Si (Si: 0.5%) and effect film formation of a metal such as Al, Al-Si, etc. as a deposition speed of about 100 nm/min (10000 Å/min.) on the substrate. This step is a non-selective deposition step. This is called the second film forming step for formation of the wiring to be connected to the electrode.

After formation of a metal film of about 500 nm (5000 Å), flowing of argon and application of DC power are stopped. After evacuation of the loadlock chamber 311 to 6.7 x 10$^{-1}$ Pa (5 x 10$^{-3}$ Torr or lower), the gate valve 310e is opened and the substrate moved. After the gate valve 310e is closed, N$_2$ gas is permitted to flow into the loadlock chamber 311 until reaching atmospheric pressure, the gate valve 310f opened and the substrate taken out of the apparatus.

According to the second Al film deposition step as described above, the Al film 406 can be formed on the SiO$_2$ film 402 as shown in Fig. 16C.

By patterning the Al film 406 as shown in Fig. 7D, wiring with a desired shape can be obtained.

As a result, the Al film formed by the sputtering method, and the Al film selectively applied to the openings are each found to be in good contact with both electrically and mechanically high durability due to good surface characteristics of the Al films.

Since the control electrode is buried in the surface of the semiconductor substrate, an insulation gate type transistor with small area and flat surface can be realised, and an insulation gate type transistor of high speed and high reliability can be obtained.

## Claims

1. An insulated gate transistor comprising:
a semiconductor body (1) having a recess therein;
a gate electrode (7) filling said recess;
an insulating film (11,12) between said gate electrode (7) and the sidewall periphery of said recess;
first and second semiconductor regions (4,5) in the surface of said semiconductor body (1), positioned each side of said gate electrode (7), and defining a source (4) and a drain (5), respectively,
a first channel means between said source (4) and said drain (5) providing a first current path (14,15) which at least in part is in directions substantially perpendicular to the surface of said semiconductor body (1); and
a second channel means between said source (4) and said drain (5) providing a second current path (16) in a direction substantially parallel to the surface of said semiconductor body (1);
said transistor being characterised by:
a high impurity doped region (13), located immediately below said gate electrode (7), disposed to lie in said first current path (14,15) and thereby providing part of said first channel means.

2. A transistor as claimed in claim 1 wherein said gate electrode (7) comprises a metal filling (111) and a polycrystalline silicon film (109) located between said filling (111) and said insulating film (11,12; 108).

3. A transistor as claimed in claim 2 wherein said metal filling is single crystalline and of aluminium, or one of the aluminium alloys Al-Si, Al-Ti, Al-Cu, Al-Si-Ti, Al-Si-Cu.

## Patentansprüche

1. Transistor mit isoliertem Gate mit:
einem Halbleiteraufbau (1) mit einer Ausnehmung darin,
einer Gateelektrode (7), die die Ausnehmung ausfüllt,
einem Isolationsfilm (11, 12) zwischen der Gateelektrode (7) und der Seitenwand-Umgebung der Ausnehmung,
ersten und zweiten Halbleiterbereichen (4, 5) an der Oberfläche des Halbleiteraufbaus (1), die sich an jeder Seite der Gateelektrode (7) befinden und jeweils einen Source-Anschluß (4) sowie einen Drain-Anschluß (5) definieren,
einer ersten Kanaleinrichtung zwischen dem Source-Anschluß (4) und dem Drain-Anschluß (5), die einen ersten Strompfad (14, 15) bildet, der zumindest teilweise in der Richtung im wesentlichen senkrecht zu der Oberfläche des Halbleiteraufbaus (1) ist, und
einer zweiten Kanaleinrichtung zwischen dem Source-Anschluß (4) und dem Drain-Anschluß (5), die einen zweiten Strompfad (16) in einer Richtung bildet, die im wesentlichen parallel zu der Oberfläche des Halbleiteraufbaus (1) ist,

**gekennzeichnet durch**

einen stark störstellendotierten Bereich (13), der sich unmittelbar unter der Gateelektrode (7) befindet, zum Liegen in dem ersten Strompfad (14, 15) angeordnet ist und dadurch einen Teil der ersten Kanaleinrichtung bildet.

2. Transistor nach Anspruch 1, **dadurch gekennzeichnet, daß** die Gateelektrode (7) eine Metallfüllung (111) und einen polykristallinen Siliziumfilm (109) aufweist, der sich zwischen der Füllung (111) und dem Isolationsfilm (11, 12; 108) befindet.

3. Transistor nach Anspruch 2, **dadurch gekennzeichnet, daß** die Metallfüllung einkristallin ist und aus Aluminium oder aus einer der Aluminiumlegierungen Al-Si, Al-Ti, Al-Cu, Al-Si-Ti, Al-Si-Cu besteht.

## Revendications

1. Transistor à grille isolée comprenant:

un corps (1) semiconducteur ayant un évidement;

une électrode (7) de grille remplissant ledit évidement;

un film (11,12) isolant entre ladite électrode (7) de grille et la périphérie de la paroi latérale dudit évidement;

des première et seconde régions (4,5) semiconductrices dans la surface dudit corps (1) semiconducteur, placées de part et d'autre de ladite électrode (7) de grille, et définissant respectivement une source (4) et un drain (5),

un premier moyen à canal entre ladite source (4) et ledit drain (5) produisant un premier trajet (14, 15) de courant au moins en partie dans des directions sensiblement perpendiculaires à la surface dudit corps (1) semiconducteur; et

un second moyen à canal entre ladite source (4) et ledit drain (5) formant un second trajet (16) de courant dans une direction sensiblement parallèle à la surface dudit corps (1) semiconducteur;

ledit transistor étant caractérisé par:

une région (13) à fort dopage par des impuretés, située immédiatement en dessous de ladite électrode (7) de grille, disposée de façon à se trouver sur ledit premier trajet (14, 15) de courant et fournissant ainsi une partie dudit premier moyen à canal.

2. Transistor selon la revendication 1, dans lequel ladite électrode (7) de grille comprend un remplissage (111) métallique et un film (109) de silicium polycristallin situé entre ledit remplissage (111) et ledit film (11, 12; 108) isolant.

3. Transistor selon la revendication 2, dans lequel ledit remplissage métallique est monocristallin et est constitué d'aluminium ou de l'un des alliages d'aluminium Al-Si, Al-Ti, Al-Cu, Al-Si-Ti, Al-Si-Cu.

# FIG. 1
## PRIOR ART

# FIG. 2
## PRIOR ART

FIG. 3
PRIOR ART

*FIG. 4 A*

*FIG. 4 B*

*FIG. 6*

FIG. 5A

103

102

101

FIG. 5B

104

FIG. 5C

105 106

FIG. 5D

107 105

FIG. 5E

FIG. 5F

FIG. 5G

FIG. 7 A

403
404
402
410
401

FIG. 7 B

405
405
405
402
401

FIG. 7 C

406
402
405
401

FIG. 7 D

406
406
402
405
401